Europäisches Patentamt

European Patent Office

Office européen des brevets

(19)

(11) Publication number: **0 413 595 A2**

# EUROPEAN PATENT APPLICATION

(21) Application number: **90309040.5**

(22) Date of filing: **17.08.90**

(51) Int. Cl.⁵: **H01L 33/00, H01L 21/20**

(30) Priority: **17.08.89 JP 211801/89**

(43) Date of publication of application:
**20.02.91 Bulletin 91/08**

(84) Designated Contracting States:
**DE FR GB**

(71) Applicant: **SEL SEMICONDUCTOR ENERGY LABORATORY CO., LTD.**
**398 Hase**
**Atsugi-shi Kanagawa-ken 243(JP)**

(72) Inventor: **Yamazaki, Shunpei**
**21-21, Kitakarasuyama, 7-chome,**
**Setagaya-ku**
**Tokyo, 157(JP)**
Inventor: **Itoh, Kenji**
**Lions Mansion Zama 705, 3-5755-1, Iriya**
**Zama-shi, Kanagawa-ken, 228(JP)**
Inventor: **Kadono, Masaya**
**Flat SEL 106, 304-1, Hase**
**Atsugi-shi, Kanagawa-ken, 243(JP)**
Inventor: **Hirose, Naoki**
**1-19 Shioirimachi**
**Shimonoseki-shi, Yamaguchi-ken, 750(JP)**

(74) Representative: **Milhench, Howard Leslie et al**
**R.G.C. Jenkins & Co. 26 Caxton Street**
**London SW1H 0RJ(GB)**

(54) **Method of manufacturing electric devices.**

(57) A method of manufacturing a light emitting diamond electric device is described. Discrete single crystals of diamond are formed on a semiconductor substrate by a CVD process. The formation of these crystals is carried out by forming discrete crystallization centres on the surface of the substrate and growing a single crystal at each centre. The spaces separating the crystals are filled with an electrically insulating material with the top surfaces of the crystals left exposed, and an upper electrode is provided over the insulating material and making contact with the top surfaces of the diamond crystals. When a voltage is applied between the substrate and the upper electrode, current flows in the crystals and causes them to emit light. By virtue of this method, light emitting devices having high reliability and performance can be mass produced with high yield.

FIG. 2 (D)

# METHOD OF MANUFACTURING ELECTRIC DEVICES

## BACKGROUND OF THE INVENTION

### 1. Field of the Invention

The present invention relates to a method of manufacturing electric devices and, more particularly to a method of manufacturing electric device utilizing crystalline films, such as diamond light emitting devices for example.

### 2. Description of the Prior Art

There have been many electric devices utilizing thin film semiconductors. The manufacturing methods of such devices require suitable measures to overcome peculiar problems originating from thin film semiconductors.

For emission of reddish light. GaAs semiconductors have been utilized to manufacture light emitting devices for more than a decade. The emission of blue or green, light, as well as white light, however, has long been hardly realized by means of solid state devices.

It has previously been proposed to make a light emitting device from a diamond film which can emit light at short wavelengths, for example as described in Japanese Patent Application No. Sho 56-146930 filed on September 17, 1981. Diamond is promising as a light emitting substance for mass production, because of its high thermal resistance, chemical stability and low price, in view of the great demand that exists for light emitting devices. It is, however, very difficult to manufacture diamond light emitting devices at the high yield rates that are required for commercialization because a large proportion of products are formed whose efficiencies are too low to satisfy the requirements of their applications. Furthermore, the performance of prior art diamond devices has tended to age quickly during operation. For example, prior art diamond light emitting devices were heated up to $50^{\circ}$ C only by application of 30 V for 10 min. and the performance of the devices was then significantly degraded.

The light emitting action of diamond light emitting devices takes place when a relatively large current is passed through diamond crystals by applying a voltage between a pair of electrodes sandwiching the diamond crystals. The electric energy carried by the current, however, is consumed largely only to produce heat rather than to emit light. We have investigated the origin of low efficiency and heat generation in diamond light emitting devices and we have discovered the following.

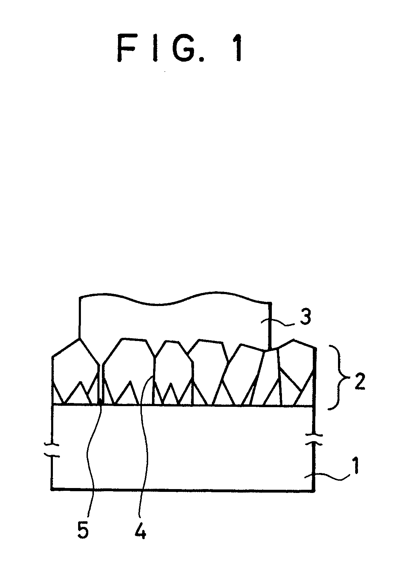

When deposited, diamond tends to form a polycrystalline film 2 composed of columnar crystals grown at right angles to a substrate surface as illustrated in Fig. 1. There are formed many grain boundaries 4 extending through the diamond film 2. It was found by Raman spectroscopic analysis that these grain boundaries result from segregation of carbon graphite (having $sp^2$ bonds) which has a resistivity substantially lower than that of diamond crystals (having $sp^3$ bonds), e.g. by a factor of $10^2$ - $10^4$. Furthermore, these boundaries tend to gather impurities such as metallic ions occurring inadvertently or introduced intentionally into the diamond films, particularly during thermal treatment. The metallic ions or other impurities also function to elevate the conductivity of the boundaries. Because of this when a voltage is applied across the film a large proportion of the resulting current flows across the film along the boundaries rather than through the diamond crystals. It is for this reason that prior art diamond electric devices have not exhibited the performance which would be expected from the inherent characteristics of diamond itself. The current passing through the boundaries makes no contribution to light emission but only functions to generate heat. Another origin of heat generation is the existence of pinholes 5 passing through the film 2 which are undesirably but often formed during deposition. When an upper electrode 3 is deposited, short circuiting current paths are undesirably formed. Similar drawbacks commonly exist in other crystalline films.

## OBJECTS AND SUMMARY OF THE INVENTION

It is thus an object of the present invention to overcome or at least substantially reduce the above problems and provide a method of manufacturing crystalline film electric devices having high reliability and performance and with high yield rates in mass production.

To achieve the foregoing and other objects, the present invention proposes to form a number of crystallization centres on the surface of a substrate that is to be coated with a crystalline film, for example a semiconductor or single crystalline diamond substrate. The centres are so minute as to allow epitaxial growth of one single crystal at each centre and are so separated from each other as not to provoke substantial interference between adjacent crystals. The spaces or clearances between the crystals that are grown at these centres are then filled with an electrically insulating material in order to ensure that short circuit current paths are not formed therethrough when electrodes are applied.

The insulating material may be either organic or inorganic as long as its resistivity is sufficiently high. For example organic resins, silicon oxide or phosphosilicate glass, or other insulating glasses may be used. An electrode is formed over the insulating material in order to make contact with the top surfaces of the crystals. When columnar single crystals of diamond are formed with their (100) plane or their (110) plane as their upper surfaces, the electrode contacts the upper surfaces of the crystals either directly or through a buffer layer while other side surfaces of the crystals are insulated by the insulating material.

By virtue of this structure, the electrode makes electrical contact only with diamond crystals at their top surfaces and therefore when a voltage is applied electrical current passes through the insides of the crystals. This current induces recombination of electron-hole pairs between mid-gap states (radiation centres), between the mid-gap states and the valence band, between the conduction band and the mid-gap states and between the conduction band and the valence band. The spectrum of light emitted from a diamond film is determined by differential energy levels between the mid-gap states, the bottom of the conduction band and the apex of the valence band. Depending upon the differential levels, it is possible to emit blue or green light or radiation having a continuous spectrum of wavelengths over a relatively wide range such as white light.

The above discussion is generally applicable to crystalline films consisting of columnar crystals, and therefore the present invention has general applicability to other crystalline materials than diamond.

The foregoing and further features of the present inventions are set forth with particularity in the appended claims and will best be understood from consideration of the following detailed description of exemplary embodiments given with reference to the accompanying drawings.

## BRIEF DESCRIPTION OF THE DRAWINGS

Fig. 1 is a cross-sectional view showing a prior art diamond light emitting device;

Figs. 2(A) to 2(D) are cross-sectional views showing a method of manufacturing diamond light emitting devices in accordance with a first embodiment of the present invention;

Figs. 3(A) and 3(B) are diagrams showing the spectra of illumination emitted from diamond light emitting devices manufactured in accordance with the first embodiment of the present invention; and

Figs. 4(A) to 4(C) are cross-sectional views showing second, third and fourth embodiments of the present invention.

## DETAILS DESCRIPTION OF THE EMBODIMENTS

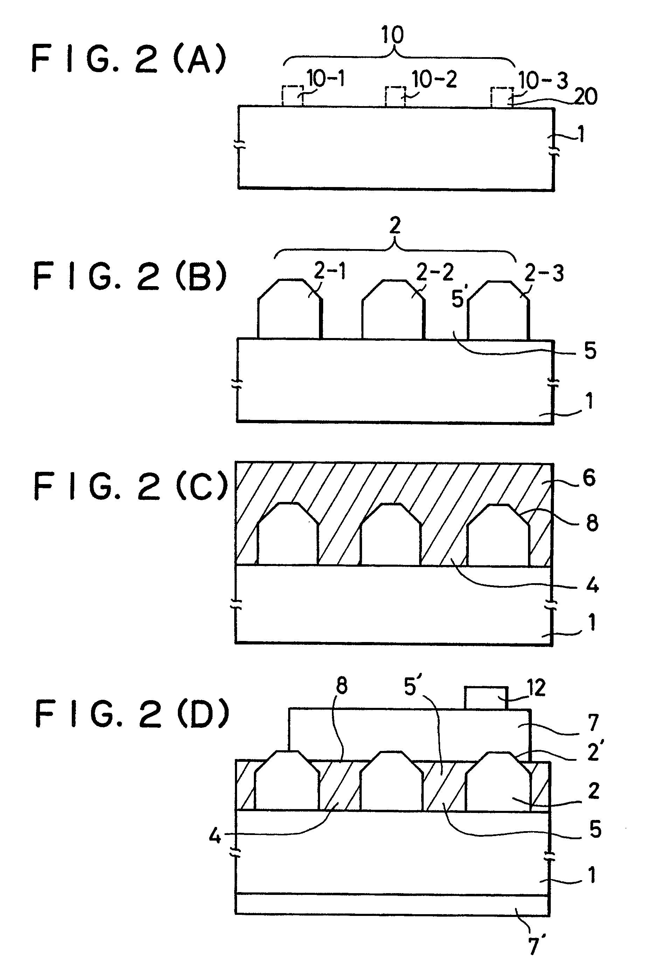

Referring now to Figs. 2(A) and 2(C), a method of forming a diamond light emitting device in accordance with a first embodiment of the invention will be explained. A silicon semiconductor substrate is heavily doped with boron ions or phosphorus ions in order to be a p-type or n-type impurity semiconductor substrate having a low resistivity. The surface of the substrate upon which the diamond crystals are to be formed is first finely scratched by putting it in an alcohol in which fine diamond particles are dispersed and applying ultrasonic waves thereto for from 10 min. to 1 hour. The scratches form focuses on the surface of the substrate for growing diamond crystals therefrom. A silicon oxide film is then coated over the scratched surface and is patterned by photoetching to leave a mask 10 consisting of a number of discrete segments 10-1, 10-2 and 10-3 which are from 0.2 to 2.0 micrometers square, e.g. 1 micrometer square. These segments are separated from each other by distances of from 10 to 50 micrometers in order not to provoke interference therebetween. The scratched surface coated with the mask 10 is next subjected to argon ion bombardment in order to make the surface amorphous except for the surface portions which are protected by the mask 10. Then, by removing the mask 10, a number of crystallization centres are defined within an amorphous surface from which crystal growth hardly occurs. Next, diamond single crystals are grown from the crystallization centres formed on the surface by a known microwave-assisted plasma CVD method in a magnetic field. Such CVD methods include ECR CVD or MCR CVD as described in Japanese Patent Application No. Sho 61-292859 filed on December 8th, 1986 and U.S. Patent Application No. 07/178,362, and in European Patent Application No. 88301364.1 (EP-A-0284190).

The microwave CVD process for forming the diamond crystals is carried out in a plasma CVD chamber provided with a microwave oscillator capable of emitting microwaves at 2.45 GHz at a maximum output power of 10 KW, and further provided with a pair of Helmholtz coils. The coils are energized to a maximum input power of 2 KW during the deposition to induce a magnetic field having a resonating strength of 875 Gauss at the surface of the substrate. The deposition of carbon (growth of diamond) is carried out in accordance with the following procedure.

The substrate with its formed crystallization centres is disposed in the plasma CVD chamber in order to be subjected to magnetic field of 755 Gauss. After evacuating the inside of the chamber to $10^{-3}$ to $10^{-6}$ Torr, a reactive gas is introduced to a pressure of 0.01 to 5 Torr, e.g. 0.26 Torr. The reactive gas comprises an alcohol such as methyl alcohol ($CH_3OH$) or ethyl alcohol ($C_2H_5OH$) diluted with hydrogen at a volume ratio of alcohol/hydrogen = 0.2 to 2. In the case of methyl alcohol, the ratio is selected to be for example 0.5. In the case of ethyl alcohol, the ratio is selected to be for example 0.25. Instead of these alcohols, carbon compounds comprising hydrogen and fluorine such as $CH_3F$, $CH_2F_2$, $C_2H_5F$, $C_2H_4F_2$ or $C_2H_3F_3$ diluted by hydrogen can be employed. Then, microwave radiation is injected at 2.45 GHz in a direction parallel to the direction of the magnetic field to cause ionized particles of the reactive gas in the form of plasmas to resonate therewith in the magnetic field. The input power of the microwaves is 5 KW. As a result, a number of columnar crystals 21-1, 21-2 and 21-3 of diamond epitaxially grow from the crystallization centres formed on the substrate. During the crystal growth, no interference between adjacent diamond crystals occurs since there is a sufficient spacing therebetween. The deposition is substantially single crystalline expitaxial growth and therefore no graphite is formed. The columnar crystals are grown to a height of from 0.5 to 10 micrometers, e.g. 1.3 micrometers, when the CVD process is continued for 2 hours.

Next, a positive photoresist 6 is coated on the substrate over the diamond crystals 2 by a spin coating method. The photoresist is preferably chosen from transparent photoresists such as OFPR 800 having a viscosity of rank C which is diluted four times by a thinner to have an appropriate viscosity. The photoresist is then baked at 80°C for 20 min. and exposed to ultraviolet light illumination from its upper side at 2mW/cm² for about 6 seconds. The duration of this exposure to illumination is precisely adjusted in order to develop the photoresist only to a level designated by a broken line spaced from the upper surface thereof (Fig. 2-(c)). Namely, the photoresist is only developed to a plane which is perpendicular to the drawing sheet and slightly lower than the top surfaces of the diamond crystals, leaving the portion below the plane undeveloped and filling the spaces between the diamond crystals. The developed portion of the photoresist is removed by a solution (NMD-3). The undeveloped portion is left as it is or may be thermally cured (hardened) if necessary.

By this procedure, the formation of undesirable current paths is prevented and current can only flow from the top surface to the bottom surface of the diamond crystals. The upper surface of the structure is then coated with an upper electrode 7 made of indium tin oxide (ITO) or zinc oxide in direct electrical contact with the diamond crystals. On the electrode 7 there is formed a lead electrode 12 which is made from a multilayered film consisting of aluminium silver and/or molybdenum films. The lead electrode 12 may be formed by an aluminium film alone, or may be a dual film consisting of a lower chromium or wolfram film and an upper aluminium film coated thereon. The lower chromium or wolfram film is highly heat-resistant and has high stability while the upper aluminium film is suitable for wire bonding.

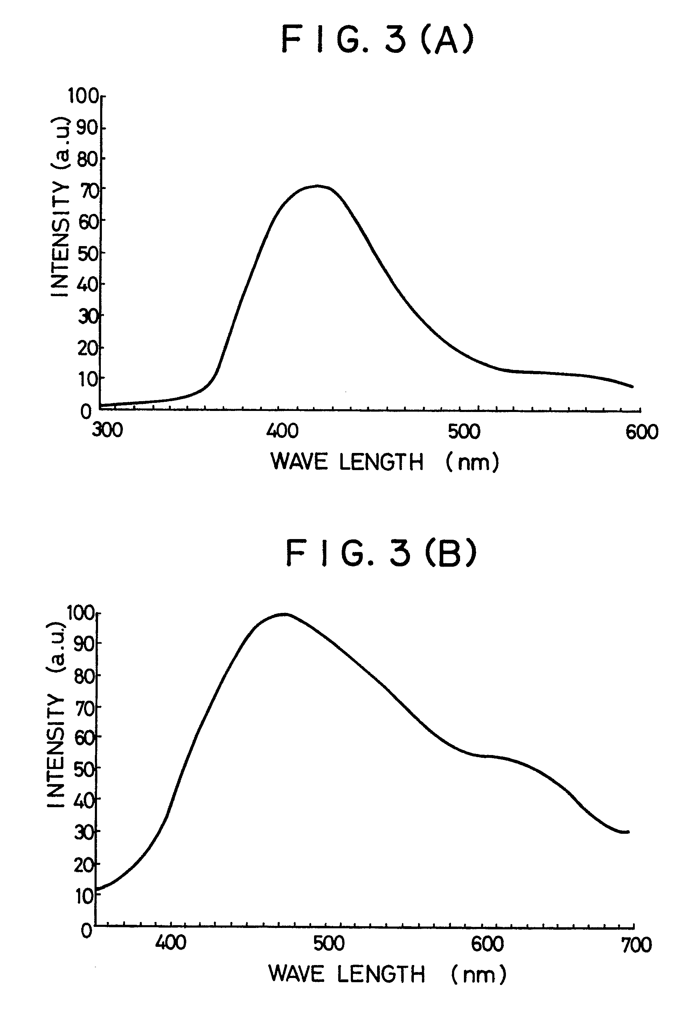

When a voltage of from 5 to 100 V (e.g. 60 V) was applied across the diamond crystals of a diamond light emitting device formed in accordance with the above procedure by means of the upper electrode 7 and the substrate 1 functioning as the counterpart lower electrode, the diamond crystals emitted green visible light by virtue of the current passing therethrough. The voltage may be applied as a DC voltage or as a pulse train at 100 Hz with a duty cycle of 50%. The spectra of the light output is as shown in Fig. 3(a). A peak of intensity appears at about 470 nm. The correspondence of the cathode luminescence is as shown in Fig. 3(B). The peak of this diagram is shifted toward the short wavelength region. The light output was not appreciably reduced even when application of 60 V was continued for a month.

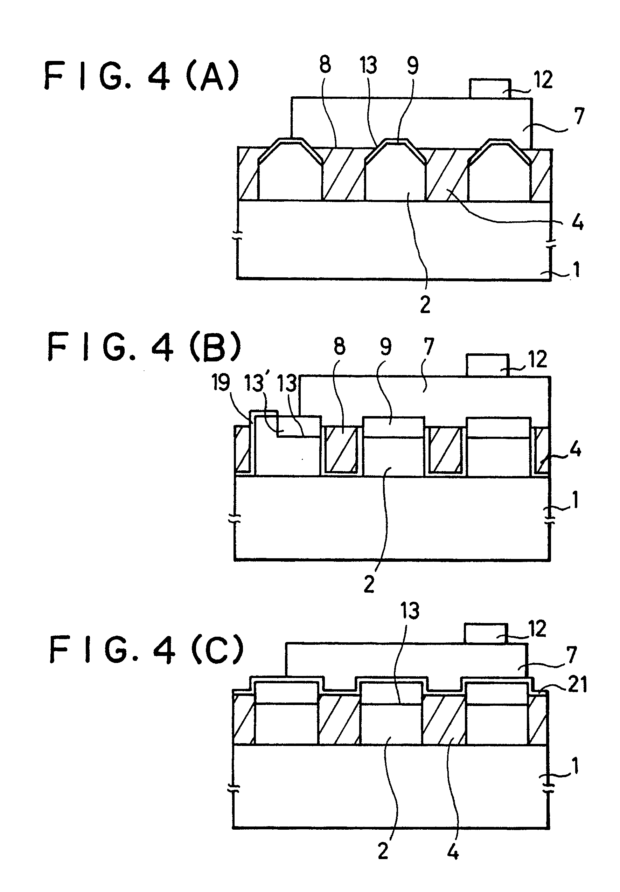

Referring to Fig. 4(A), a light emitting device in accordance with a second embodiment of the present invention is illustrated. A number of diamond crystals 2 of 0.5 to 10 micrometers in height, e.g. 2.5 micrometers, are formed on a silicon semiconductor substrate 1 with the aid of crystallization centres formed on the surface of the substrate in the same manner as described above for the first embodiment. During the CVD process of diamond crystal formation, however, diborane is introduced as a dopant gas in order to make the diamond crystals p-type. The top surfaces of the diamond crystals 2 are doped with oxygen and, if desired, phosphorus by ion implantation. The concentration of oxygen is for example $5 \times 10^{18}$ cm$^{-3}$. The concentration of phosphorus is for example $3 \times 10^{18}$ cm$^{-3}$. Sulphur or selenium may be used instead for the same purpose. Undesirable defects, which might be formed by the ion implantation, are cured by laser annealing with an excimer laser or by thermal annealing in a vacuum. By virtue of these treatments, a number of recombination centres can be formed in the top surface of the diamond crystals. A filling of insulating material 4 and an electrode arrangement 7 and 12 are provided in the same manner as for the first embodiment. When 12 V was applied between the electrode 7 and the substrate of a light emitting device formed by this procedure, 6 cd/m$^2$ light emission was observed at 450 nm wavelength.

Referring now to Fig. 4(B), a third embodiment of the present invention will be explained. A number of diamond crystals are formed in the same manner as for the previous embodiment with their (100) plane as their top surfaces. The reactive gas, however, comprises carbon monoxide (CO) and hydrogen. The substrate temperature should therefore be maintained at about 650°C. A silicon nitride film of 0.1 to 0.5 micrometer thickness is deposited on the substrate 1 conformly over the diamond crystals 2. Spaces between the crystals 2 are filled with an organic glass such as $(CH_3)_3OH$ and $(C_2H_5)_4O_4Si$ by a spin coating method. The organic component of the glass coating is driven off by heating at 200 to 500°C, e.g. 400°C, in order to leave an inorganic glass comprising mainly silicon oxide. Excess inorganic glass beyond the crystals 2, if any, should be removed thereafter. The surfaces of the diamond crystals are doped with an impurity, e.g. phosphorus, oxygen, sulphur and/or selenium through a mask. The region of the crystals to be doped is selected in correspondence with an electrode which is to be provided in a later step. At the same time, the silicon nitride film 19 is correspondingly removed using the same mask. The structure is then laser annealed. The annealing can be carried out under pressure at a temperature of 700 to 1400°C since the insulating material filling the spaces is composed mainly of silicon oxide, and the external surfaces of the diamond crystals are protected by the silicon nitride film 19 so the perimeters of the crystals do not separate from the insulating material. Light emitting devices formed by this procedure can be used as blue light or green light sources.

Referring now to Fig. 4(C), a fourth embodiment of the present invention will be explained. A number of diamond crystals are formed on a substrate in the same manner as for the previous embodiment. The surfaces of the diamond crystals are doped with an impurity, e.g. phosphorus, oxygen, sulphur and/or selenium. After filling the spaces between the crystals with an insulating material, a buffer layer film made of a rare earth metal oxide such as hafnium oxide film is deposited to 0.1 to 0.5 micrometer by sputtering. An electrode 7 is provided in order to make contact with the doped diamond crystals 2 only through the buffer layer 21. Light emitting devices formed by this procedure can be used as blue light sources.

Similar electric devices can be formed by use of crystalline boron nitride films instead of the diamond films described in accordance with any of the above embodiments. The method and structure are substantially the same as described above except as particularly provided in the following. In this case, suitable substrates to be coated with crystalline boron nitride are made from, for example, beryllium nitride, diamond or a silicon semiconductor. The suitable reactive gases are, for example, boron source gases such as diborane ($B_2H_6$), boron fluoride ($BF_3$), organic boron compounds, and methylboron ($B(CH_3)_3$), and a nitrogen source gases such as ammonia ($NH_3$), nitrogen ($N_2$), and nitrogen fluoride ($NF_3$). The boron source gases and the nitrogen source gases are used in combination. Some gaseous compounds such as borofluoric ammonium ($NH_4BF_4$) function both as boron and nitrogen source gases and can be used alone without another reactive gas. The pressure of reactive gases during deposition is 0.01 to 10 Torr, typically 0.1 to Torr, e.g. 0.26 Torr. The microwave input power is 2 to 10 KW. The height of the boron nitride columnar crystals is 0.5 to 5 micrometers, e.g. 1.3 micrometers, on average. The substrate temperature is 400 to 1200°C, e.g. 1000°C. Other conditions are the same as in the above embodiments.

The foregoing description of preferred embodiments has been presented for purposes of illustration and is not intended to be exhaustive or to limit the invention to the precise form described, and obviously many modifications and variations are possible. For example, although the photoresist is positive in the first embodiment, a negative photoresist can be used when the electric device is constructed on a transparent substrate. In this case, the negative photoresist is cured by illumination effected from the substrate side.

The present invention is broadly applicable to any electric device which utilizes a crystalline film-like structure. The electric devices of the invention can be formed on a single substrate, i.e. an integrated circuit device which may consist of diamond light emitting devices, diamond diodes, diamond transistors, diamond resistances, diamond capacitors and the like. Of course, it is possible to sever a single substrate, after a number of diamond devices are formed on the substrate, into individual separate devices.

## Claims

1. A method of manufacturing electric devices comprising:

forming a number of discrete crystallization centres on a surface;

growing a single crystal at each crystallization centre; and

filling spaces between said single crystals with an electrically insulating material with the top surfaces of said crystals exposed.

2. The method of claim further comprising forming an electrode on said insulating material and said single crystals such that said electrode makes electrical contact with said single crystals only at said top surfaces thereof.

3. . The method of claim 1 or 2 wherein said single crystals comprise diamond.

4. The method of any preceding claim wherein said surface is a surface of a semiconductor substrate.

5. The method of claim 4 wherein said crystallization centres are formed on said surface by scratching discrete areas of said surface.

6. The method of claim 5 wherein the portion of said surface that has not been given scratches is made amorphous.

7. The method of claim 6 wherein said amorphous surface is formed by ion bombardment of the surface.

8. The method of any preceding claim wherein said growing step is carried out by microwave enhanced CVD.

9. The method of claim 8 wherein said CVD is carried out in a magnetic field.

10. The method of any preceding claim wherein the filling of said insulating material into spaces between the single crystals is carried out by coating a photoresist on said surface over said crystals, partially developing said photoresist by illumination and removing the portion of said photoresist covering the top surfaces of said crystals.

11. An electric device manufactured by the method of any of the preceding claims.

12. An electric device of claim 11 adapted for use as a light emitting device.

# F I G. 1

FIG. 2 (A)

FIG. 2 (B)

FIG. 2 (C)

FIG. 2 (D)

8

# F I G. 3 (A)

# F I G. 3 (B)

FIG. 4 (A)

FIG. 4 (B)

FIG. 4 (C)